# EUROPÄISCHE PATENTANMELDUNG

(11) **EP 4 516 485 A1**
(43) Veröffentlichungstag der Anmeldung: **05.03.2025**
(21) Anmeldenummer: 24195544.2
(22) Anmeldetag: 21.08.2024
(51) Int. Cl.: B29C 64/135, B29C 64/277, B29C 64/393, B29C 64/264, B29C 64/268, B29C 64/273, B33Y 10/00, B33Y 30/00, B33Y 50/02

(54) **VERFAHREN ZUM ERZEUGEN EINER DREIDIMENSIONALEN STRUKTUR UND LASERLITHOGRAFIE-VORRICHTUNG**

(30) Priorität: 31.08.2023 DE 102023123551
(71) Anmelder: Nanoscribe Holding GmbH, 76344 Eggenstein-Leopoldshafen (DE)
(72) Erfinder: Blaicher, Matthias, 76297 Stutensee (DE); Xu, Yilin, 72827 Wannweil (DE)
(74) Vertreter: DREISS Patentanwälte PartG mbB

(57) **Zusammenfassung**

Verfahren zum Erzeugen einer dreidimensionalen Struktur in einem Lithografiematerial (12), wobei das Verfahren die folgenden Schritte aufweist: Aufnehmen des Lithografiematerials (12) mittels einer Lithografiematerial-Aufnahme (14); Erzeugen eines Eingangs-Laserstrahls (20) mittels einer Laserstrahlquelle (18); Demultiplexen des Eingangs-Laserstrahls (20) zum zeitlichen Aufteilen des Eingangs-Laserstrahls (20) zur Ausbildung einer Mehrzahl von Laser-Schreibstrahlen (26); Fokussieren der Mehrzahl von Laser-Schreibstrahlen (26) mittels eines Objektivs (70); Erzeugen der dreidimensionalen Struktur in dem Lithografiematerial (12) mittels der fokussierten Laser-Schreibstrahlen (26).

## Beschreibung

Die Erfindung betrifft ein Verfahren zum Erzeugen einer dreidimensionalen Struktur und eine Laserlithografie-Vorrichtung.

Die im vorliegenden Zusammenhang mit Laserlithografie bezeichnete Technik wird beispielsweise auch als Stereo-Lithografie oder direktes Laserschreiben (englisch: direct laser writing) bezeichnet. Bei dieser Technik werden Strukturen mittels eines Laser-Schreibstrahls in eine in der Regel zunächst flüssige, fotosensitive Substanz geschrieben, die im vorliegenden Zusammenhang als Lithografiematerial bezeichnet wird. Hierbei wird durch den Laser-Schreibstrahl in dem Lithografiematerial lokal ein Verfestigungseffekt ausgelöst. Die Verfestigung erfolgt dabei beispielsweise aufgrund einer durch Photonen-Absorption induzierte, lokale Polymerisation des Lithografiematerials. Im Bereich der optischen Lithografie wird ein derartiges Lithografiematerial auch als Fotolack bezeichnet. Im Bereich der Stereolithografie spricht man auch von Resin oder Harz.

Die Technik der Laserlithografie bzw. des direkten Laserschreibens wird in vorteilhafterweise bei der Erzeugung von Mikro- oder Nanostrukturen eingesetzt, wenn eine hohe Präzision erwünscht ist und gleichzeitig Gestaltungsfreiheit und Flexibilität in der Formgebung erhalten bleiben soll. Anders als zum Beispiel bei Verfahren der Maskenlithografie können nämlich verschiedene Strukturen geschrieben werden, ohne dass die Struktur durch eine Maske oder Ähnliches vorgegeben ist.

Hierbei sind verschiedene Techniken bekannt, die in unterschiedlichem Maße zu einem direkten Kontakt zwischen der Fokussieroptik bzw. deren optischem Abschlusselement und dem Lithografiematerial führen können. Grundsätzlich ist es zunächst bekannt, dass die gewünschte Gesamtstruktur dadurch erzeugt wird, dass sequentiell eine Reihe von Teilstrukturen (beispielsweise lagenweise oder scheibenweise) geschrieben werden, die sich dann insgesamt zu der gewünschten Struktur ergänzen.

Bei einer Art bekannter Techniken trifft der Schreibstrahl auf die Oberfläche eines Volumens an Lithografiematerial und führt an der Oberfläche zu einer lokalen Verfestigung. In der Regel liegen diesen Verfahren lineare Prozesse wie Ein-Photonen-Absorption und daraus resultierende, lokale Veränderung des Lithografiematerials zugrunde. Um dreidimensional ausgedehnte Strukturen zu schreiben, wird bei derartigen Verfahren nach dem Beschreiben einer Lage in einem Applikationsschritt eine zusätzliche Lage Lithografiematerial aufgetragen. Dies kann beispielsweise dadurch erreicht werden, dass ein Substrat mit der hierauf zu schreibenden Struktur schrittweise in einem Bad aus Lithografiematerial abgesenkt wird und die Strukturierung mittels des Schreibstrahls jeweils an der Oberfläche erfolgt. Bei derartigen Techniken kann es vorkommen, dass das Abschlusselement der Fokussieroptik mit Lithografiematerial in Kontakt gerät.

Ein anderer Ansatz nutzt das physikalische Prinzip der Zwei-Photonen-Polymerisation oder allgemein Multi-Photonen-Polymerisation aus, um eine Verfestigung von Lithografiematerial auch innerhalb eines Volumens an Lithografiematerial, also auch unterhalb der Oberfläche zu erzielen. Dies wird dadurch ermöglicht, dass Schreibstrahl und Lithografiematerial derart aufeinander abgestimmt sind, dass ein Verfestigungseffekt unter Mitwirkung nichtlinearer Effekte erfolgt. Beispielsweise wird der Schreibstrahl in einem Spektralbereich gewählt, der normalerweise keinen Verfestigungseffekt in dem Lithografiematerial auslösen kann. Beispielsweise können Lithografiematerial und Schreibstrahl derart aufeinander abgestimmt sein, dass eine induzierte Verfestigung nur unter Absorption von zwei oder mehr Photonen des Schreibstrahls erfolgt (Zwei-Photonen-Polymerisation oder Multi-Photonen-Polymerisation). Im vorliegenden Zusammenhang wird mit dem Begriff Multi-Photonen-Polymerisation die induzierte Polymerisation durch Absorption von zwei oder mehr als zwei Photonen bezeichnet. Insofern schließt für die vorliegende Beschreibung der Begriff "Multi-Photonen-Absorption" auch den Prozess der "Zwei-Photonen-Absorption" und "Zwei-Stufen-Absorption" mit ein. Die für eine Multi-Photonen-Polymerisation erforderlichen Bedingungen werden in der Regel nur in einer Zone erhöhter Intensität erreicht. Diese Zone erhöhter Intensität wird typischerweise in einem Bereich um einen Fokus des Laser-Schreibstrahls bereitgestellt. Der Fokus ist insofern eine Strahltaille des Laser-Schreibstrahls, welche durch geeignete Optiken, beispielsweise eine Strahlführungsoptik, eine Strahlformungsoptik und/oder ein Objektiv, erzeugt wird. Zur lithografischen Herstellung von ausgedehnten 3D-Strukturen kann dann der Fokus nach Maßgabe von Geometriebeschreibungsdaten durch ein Volumen an Lithografiematerial bewegt werden und jeweils lokal einen Verfestigungsprozess auslösen.

Die Herstellung von dreidimensionalen Strukturen mittels Zwei-Photonen-Polymerisation erfolgt oft mit einem Arbeitsabstand von 100 µm (Mikrometer) bis 20 mm (Millimeter). Dabei ist der Arbeitsabstand ein Abstand zwischen dem Fokus und einem optischen Abschlusselement eines Objektivs zur Erzeugung des Fokus. Bei derart geringen Arbeitsabständen kann ein Kontakt des Objektivs mit dem Lithografiematerial oftmals nicht verhindert werden. Insbesondere taucht das Objektiv in das Lithografiematerial ein. Ein Herstellungsverfahren, bei dem das Objektiv zumindest teilweise in das Lithografiematerial eintaucht, kann auch als Dip-In Multi-Photonen-Polymerisation bezeichnet werden. Dabei gelangt das Lithografiematerial während der Herstellung von dreidimensionalen Strukturen häufig an das Objektiv und insbesondere an das optische Abschlusselement.

Unabhängig von der konkreten Technik besteht eine Herausforderung darin, dass der Schreibprozess für komplexe Strukturen zeitaufwändig sein kann, und eine Beschleunigung in der Regel nicht auf Kosten der Präzision erfolgen soll.

EP 4 163 083 A1 zeigt eine Vorrichtung zur lithografiebasierten Fertigung eines dreidimensionalen Bauteils. Die Vorrichtung hat einen Strahlteiler zur Aufteilung eines Eingangsstrahls in mehrere Strahlen, die auf Fokuspunkte innerhalb eines Materials fokussiert werden. Weiter hat die Vorrichtung eine der Anzahl der Strahlen entsprechende Anzahl von akustooptischen Modulatoren. In jedem Strahlengang der Strahlen ist ein akustooptischer Modulator zum Verlagern des Fokuspunkts des jeweiligen Strahls angeordnet.

Der Erfindung liegt die Aufgabe zugrunde, bei der Technik der Laserlithografie insbesondere ein schnelles Herstellen von dreidimensionalen Strukturen zu ermöglichen.

Gelöst wird diese Aufgabe durch ein Verfahren mit den Merkmalen des Anspruchs 1 und durch eine Laserlithografie-Vorrichtung mit den Merkmalen des Anspruchs 7. Vorteilhafte und bevorzugte Ausgestaltungen der Erfindung sind in den weiteren Ansprüchen enthalten.

Das erfindungsgemäße Verfahren zum Erzeugen einer dreidimensionalen Struktur in einem Lithografiematerial weist die Schritte auf: Aufnehmen des Lithografiematerials mittels einer Lithografiematerial-Aufnahme; Erzeugen eines Eingangs-Laserstrahls mittels einer Laserstrahlquelle, wobei der Laserstrahl sich in eine Ausbreitungsrichtung ausbreitet; Bilden einer Mehrzahl, insbesondere drei, vier oder fünf, von Laser-Schreibstrahlen durch Demultiplexen des Laserstrahls mittels einer Demultiplexer-Einheit, die zwischen der Laserstrahlquelle und einem Objektiv angeordnet ist; Fokussieren der Mehrzahl von Laser-Schreibstrahlen mittels des Objektivs; Erzeugen der dreidimensionalen Struktur in dem Lithografiematerial mittels der fokussierten Laser-Schreibstrahlen.

Durch das Demultiplexen des Laserstrahls werden mehrere Laser-Schreibstrahle erzeugt, wobei dann die dreidimensionale Struktur mittels der mehreren Laser-Schreibstrahlen erzeugt werden kann. Dadurch wird eine Dauer für ein Verlagern des Lithografiematerials relativ zu einem Laser-Schreibstrahl reduziert und damit ein besonders schnelles Herstellen der dreidimensionalen Struktur ermöglicht.

Besondere Vorteile kann die Aufteilung des Laser-Schreibstrahls durch zeitliches Demultiplexen für die Laserlithografie bei Anwendung der Zwei-Photonen-Polymerisation oder Multi-Photonen-Polymerisation bringen. Dabei wird das Lithografiematerial aufgrund eines nichtlinearen Prozesses in einem belichteten Zustand überführt, insbesondere auspolymerisiert oder verfestigt. Daher stellt bei Verwendung eines gepulsten Laserstrahls die Peak-Leistung der einzelnen Laserpulse des Laserstrahls eine für den Prozess der Zwei-Photonen-Polymerisation oder Multi-Photonen-Polymerisation relevante Größe dar. Durch das zeitliche Demultiplexen des Laserstrahls wird erreicht, dass Laser-Schreibstrahlen erzeugt werden, die eine höhere Peak-Leistung aufweisen als Laser-Schreibstrahlen, die durch kontinuierliches Strahlteilen, beispielsweise mittels eines Strahlteilers, erzeugt werden. Unter kontinuierliches Strahlteilen kann ein zeitlich-kontinuierliches Strahlteilen oder ein passives kontinuierliches Strahlteilen verstanden werden. Das kontinuierliche Strahlteilen kann mittels eines passiven optischen Elements erfolgen. Somit verbessert das zeitliche Demultiplexen die Prozesseffizienz bei der Zwei-Photonen-Polymerisation oder Multi-Photonen-Polymerisation.

Die Laserstrahlquelle kann als Laserdiode ausgebildet sein.

Die Laser-Schreibstrahlen treffen auf das Lithografiematerial oder werden in das Lithografiematerial fokussiert. Die Laser-Schreibstrahlen und das Lithografiematerial können derart aufeinander abgestimmt sein, dass das Lithografiematerial zur Erzeugung der dreidimensionalen Struktur mittels Multi-Photonen-Polymerisation lokal innerhalb einer Mehrzahl von Bereichen in oder um jeweils die Fokusse der Laser-Schreibstrahlen in einem belichteten Zustand überführbar ist, insbesondere auspolymerisierbar oder verfestigbar.

Die Laser-Schreibstrahlen können eine Frequenzverdopplungs-Einrichtung zum Verdoppeln einer Frequenz der Laser-Schreibstrahlen durchlaufen. Die Frequenzverdopplungs-Einrichtung kann zwischen der Wellenleiter-Anordnung und dem Objektiv angeordnet sein. Die Frequenzverdopplungs-Einrichtung kann einen nichtlinearen Kristall, beispielsweise einen Lithiumniobat-Kristall, aufweisen. Der nichtlineare Kristall kann zu den Laser-Schreibstrahlen derart phasenangepasst angeordnet sein, dass zumindest ein Teil eines jeden Laser-Schreibstrahls nach dem Durchlaufen des nichtlinearen Kristalls frequenzverdoppelt ist. Die Frequenzverdopplungs-Einrichtung kann von einer Haltematrix gehalten sein.

Die Lithografiematerial-Aufnahme kann dazu ausgebildet sein, das Lithografiematerial zum Zweck des Herstellens der dreidimensionalen Struktur aufzunehmen. Insbesondere ist vorgesehen, dass die Lithografiematerial-Aufnahme ein Volumen an Lithografiematerial derart aufnehmen kann, dass die Laser-Schreibstrahlen in das Lithografiematerial fokussierbar sind. Die Lithografiematerial-Aufnahme kann das Lithografiematerial derart aufnehmen, dass das Objektiv in das Lithografiematerial zum Zweck des Herstellens der dreidimensionalen Struktur eintauchbar ist.

Vorzugsweise ist die Lithografiematerial-Aufnahme dazu ausgebildet, das Lithografiematerial für das Erzeugen der dreidimensionalen Struktur in Position zu halten. Die Lithografiematerial-Aufnahme kann als Lithografiematerial-Träger bezeichnet werden.

Für die Lithografiematerial-Aufnahme sind verschiedene geometrische Ausgestaltungen denkbar, die jeweils verschiedene Vorteile bringen können. Die Lithografiematerial-Aufnahme kann z.B. als Wanne, Behälter oder Topf zum Aufnehmen des Lithografiematerials ausgebildet sein. Denkbar ist auch, dass die Lithografiematerial-Aufnahme als Tisch oder Träger oder Substrat ausgebildet ist, auf dem das Lithografiematerial tropfenförmig oder schichtförmig aufliegt. Denkbar ist auch, dass auf dem Tisch ein Substrat, insbesondere in Form eines Wafers, zum Erzeugen der dreidimensionalen Struktur auf dem Substrat platziert ist und auf dem Substrat das Lithografiematerial tropfenartig oder schichtförmig aufliegt. Der Tisch kann ein Maschinentisch einer Lithografie-Vorrichtung sein.

Die Lithografiematerial-Aufnahme kann zumindest bereichsweise für die Laser-Schreibstrahlen transparent ausgebildet sein. Beispielsweise können Wandungen oder Böden oder Deckplatten der Lithografiematerial-Aufnahme, soweit bei der konkreten Ausgestaltung jeweils vorhanden, für die Laser-Schreibstrahlen transparent ausgebildet sein. Dadurch kann das Fokussieren der Laser-Schreibstrahlen in das Lithografiematerial durch die Lithografiematerial-Aufnahme hindurch erfolgen. Beispielsweise kann eine Bestrahlung oder Belichtung des Lithografiematerials von unten ermöglicht werden.

Der Eingangs-Laserstrahl kann ein Dauerstrich-Laserstrahl oder ein gepulster Laserstrahl sein. Insbesondere kann ein Laserpuls des gepulsten Laserstrahls eine Pulsdauer von 50 Femtosekunden bis 500 Nanosekunden aufweisen.

Das Demultiplexen des Eingangs-Laserstrahls kann ein zeitliches und/oder räumliches Demultiplexen des Eingangs-Laserstrahls sein. Insbesondere kann das zeitliche und räumliche Demultiplexen des Eingangs-Laserstrahls simultan erfolgen. Vorzugsweise kann das Demultiplexen des Eingangs-Laserstrahls ein zeitliches und räumliches Aufteilen des Eingangs-Laserstrahls bewirken. Unter Aufteilen kann ein Ablenken, ein Richten, ein Auskoppeln oder ein Extrahieren verstanden werden. Das Aufteilen kann mittels eines optischen Schalters erfolgen. Der optische Schalter kann ein faserintegrierter optischer Schalter sein.

Das Verfahren sieht insofern insbesondere vor, eine Mehrzahl von Laser-Schreibstrahlen durch Demultiplexen des Laserstrahls mittels einer Demultiplexer-Einheit zu bilden, die zwischen der Laserstrahlquelle und einem Objektiv angeordnet ist. Das Demultiplexen bezeichnet insbesondere das Gegenteil von Multiplexen. Das Demultiplexen kann ein Richten oder Lenken von zumindest einem Leistungsanteil des Eingangs-Laserstrahls auf einen von mehreren Ausgängen der Demultiplexer-Einheit umfassen. Der auf den Ausgang gerichtete oder gelenkte zumindest eine Leistungsanteil des Eingangs-Laserstrahls kann nach dem Passieren des Ausgangs einen Laser-Schreibstrahl bilden. Das Demultiplexen kann ein abwechselndes Richten oder Lenken von zumindest Leistungsanteilen des Eingangs-Laserstrahls auf voneinander verschiedene Ausgänge der Demultiplexer-Einheit umfassen.

Falls der Eingangs-Laserstrahl ein gepulster Laserstrahl ist, kann das Demultiplexen ein Puls-Picken von einzelnen Laserpulsen oder Laserpuls-Gruppen des gepulsten Eingangs-Laserstrahls sein. Falls der Eingangs-Laserstrahl ein Dauerstrich-Laserstrahl ist, kann das Demultiplexen ein Ausbilden von gepulsten Laser-Schreibstrahlen sein, wobei insbesondere eine Pulsbreite und/oder eine Pulslänge gleich einer Schaltdauer der Demultiplexer-Einheit ist. Beispielsweise können durch die Demultiplexer-Einheit duty cycle Pulse erzeugt werden. Mit anderen Worten, ein Dauerstrich-Laserstrahl kann mittels der Demultiplexer-Einheit überpulst werden.

Das Demultiplexen des Eingangs-Laserstrahls kann zeitlich unverändert, periodisch oder in Abhängigkeit eines Signals erfolgen. Beispielsweise kann das Demultiplexen derart erfolgen, dass jeder Laser-Schreibstrahl für eine vorgegebene Zeitdauer aus dem Eingangs-Laserstrahl gebildet wird. Die vorgegebene Zeitdauer kann beispielsweise 100 Femtosekunden bis 500 Nanosekunden betragen.

Jeder Laser-Schreibstrahl kann sich entlang einer Strahlachse ausbreiten. Die Strahlachsen der Laser-Schreibstrahlen können sich voneinander unterscheiden. Die Strahlachsen der Laser-Schreibstrahlen können parallel und versetzt zueinander orientiert sein. Die Strahlachsen der Laser-Schreibstrahlen und eine Strahlachse des Eingangs-Laserstrahls können sich voneinander unterscheiden, insbesondere kann die Strahlachse des Eingangs-Laserstrahls orthogonal zu den Strahlachsen der Laser-Schreibstrahl orientiert sein. Mit anderen Worten, die Strahlachsen der Laser-Schreibstrahlen können jeweils nicht kollinear zu der Strahlachse des Laserstrahls verlaufen.

Unter Strahlachse kann eine Längsachse des jeweiligen Laserstrahls verstanden werden, die sich in Richtung seiner Ausbreitungsrichtung erstreckt. Insofern kann die Strahlachse durch den Poynting-Vektor der Strahlung definiert werden. Der Poynting-Vektor kann ein effektiver Poynting-Vektor sein. Der effektive Poynting-Vektor kann beispielsweise ein nach Intensität gewichteter, gemitteltener Pointing-Vektor sein.

Jeder Laser-Schreibstrahl kann dazu ausgebildet sein, das Lithografiematerial mittels Zwei- oder Multiphotonen-Polymerisation in einem belichteten Zustand zu überführen, insbesondere zu polymerisieren oder auf andere Art zu verfestigen.

Das Fokussieren der Mehrzahl von Laser-Schreibstrahlen kann ein Ausbilden einer Mehrzahl von Fokusse umfassen. Insbesondere werden sämtliche Laser-Schreibstrahlen mittels desselben Objektiv fokussiert, insbesondere derart, dass jeder Laser-Schreibstrahl einen eigenen, zugeordneten Fokus aufweist. Die Fokusse können räumlich und zeitlich voneinander getrennt sein. Mit anderen Worten, das Fokussieren der Mehrzahl von Laser-Schreibstrahlen kann derart erfolgen, dass die Laser-Schreibstrahlen zeitlich nacheinander und räumlich nebeneinander jeweils einen Fokus ausbilden. Vorzugsweise ist die Anordnung derart, dass die Fokusse innerhalb eines Volumens aus Lithografiematerial liegen, vorzugsweise unterhalb der Oberfläche des Lithografiematerials.

Im Zusammenhang mit dem Schritt des Fokussierens der Mehrzahl von Laser-Schreibstrahlen, insbesondere vor dem Fokussieren, kann das Verfahren den Schritt aufweisen: Eintauchen des Objektivs in das Lithografiematerial. Mit anderen Worten, das Verfahren kann ein Dip-In Multi-Photonen-Polymerisation Verfahren sein.

Das Objektiv kann beispielsweise eine numerische Apertur im Bereich von einschließlich 0,01 bis einschließlich 1,6 aufweisen. Insbesondere hohe numerische Aperturen können zu einer hohen Präzision beitragen.

Das Erzeugen der dreidimensionalen Struktur in dem Lithografiematerial kann ein räumliches Überlagern der Fokusse der Laser-Schreibstrahlen mit dem Lithografiematerial umfassen. Mit anderen Worten, die Laser-Schreibstrahlen werden in das Lithografiematerial zum Zweck des Erzeugens der dreidimensionalen Struktur fokussiert. Das Erzeugen der dreidimensionalen Struktur in dem Lithografiematerial kann mittels Multi-Photonen-Polymerisation des Lithografiematerials erfolgen.

In einer Weiterbildung des Verfahrens umfasst das Demultiplexen ein Bilden eines jeden Laser-Schreibstrahls durch Auskoppeln eines zum Überführen des Lithografiematerials in einem belichteten Zustand ausreichenden Laserstrahl-Anteils aus dem Eingangs-Laserstrahl. Insbesondere kann das Auskoppeln derart erfolgen, dass der jeweilige Laser-Schreibstrahl in seinem Fokus zumindest die für eine Zwei- oder Multiphotonen-Polymerisation des Lithografiematerials ausreichende Belichtungsdosis, Energiedosis, und/oder Intensität aufweist. Das Belichten kann mittels Zwei- oder Multiphotonen-Polymerisation erfolgen.

Beispielsweise kann das Lithografiematerial in einem unbelichteten Zustand flüssig sein und in einem belichteten Zustand fest. Mit anderen Worten, durch das lokale Überführen des Lithografiematerials in einem belichteten Zustand kann das Lithografiematerial lokal verfestigt werden. Anschließend kann das unbelichtete und flüssige Lithografiematerial von dem infolge des Belichtens verfestigte Lithografiematerial getrennt werden, z.B. im Rahmen eines Entwicklungsschritts.

In einem alternativen Beispiel kann das Lithografiematerial in einem unbelichteten Zustand fest sein und in einem belichteten Zustand kann seine Struktur, z.B. chemische Struktur, molekulare Struktur, Vernetzung des Lithografiematerials, Polymerisationsgrad o.ä. gegenüber dem unbelichteten Zustand verändert sein. Mit anderen Worten, das lokale Überführen des Lithografiematerials in einem belichteten Zustand kann durch eine Änderung der Vernetzung des Lithografiematerials erfolgen. Anschließend kann das unbelichtete Lithografiematerial von dem belichteten Lithografiematerial getrennt werden, z.B. in einem Entwicklungsschritt.

In einer Weiterbildung des Verfahrens ist der Eingangs-Laserstrahl ein gepulster Laserstrahl, der eine Mehrzahl von Laserpulsen aufweist. Das Bilden der Mehrzahl von Laser-Schreibstrahlen erfolgt durch ein Auskoppeln einer ersten Gruppe von Laserpulsen und wenigstens einer zweiten Gruppe von Laserpulsen aus dem gepulsten Eingangs-Laserstrahl. Die erste Gruppe von Laserpulsen bilden einen ersten Laser-Schreibstrahl und die zweite Gruppe von Laserpulsen bilden einen zweiten Laser-Schreibstrahl. Die erste Gruppe von Laserpulsen und die zweite Gruppe von Laserpulsen können zeitlich und räumlich voneinander getrennt sein. Das Auskoppeln kann als Puls-Picken bezeichnet werden.

In einer Weiterbildung des Verfahrens weist das Verfahren den Schritt auf: Erfassen einer Leistung des Eingangs-Laserstrahls im Strahlengang des Eingangs-Laserstrahls nach dem Demultiplexen. Das Bilden der Mehrzahl von Laser-Schreibstrahlen erfolgt in Abhängigkeit der erfassten Leistung. Das Erfassen der Leistung kann ein Erfassen der Leistung eines Reststrahls des Eingangs-Laserstrahls sein. Der Reststrahl ist vorzugsweise kein Laser-Schreibstrahl. Insbesondere kann der Reststrahl ein Laserstrahl sein, der nach dem Demultiplexen des Eingangs-Laserstrahls von dem Eingangs-Laserstrahl übrig ist. Das Demultiplexen kann mittels einer Demultiplexer-Einheit ausgeführt werden. Das Erfassen der Leistung kann nach der Demultiplexer-Einheit erfolgen. Die Leistung kann eine Leistung des Eingangs-Laserstrahls nach dem Passieren der Demultiplexer-Einheit sein.

In einer Weiterbildung des Verfahrens weist das Verfahren den Schritt auf: Einkoppeln der Mehrzahl von Laser-Schreibstrahlen in eine Wellenleiter-Anordnung, die eine Mehrzahl von Wellenleitern aufweist. Je ein Wellenleiter ist einem Laser-Schreibstrahl zugeordnet. Die Wellenleiter sind im Strahlengang zwischen der Laserstrahlquelle und dem Objektiv angeordnet. Durch die Wellenleiter-Anordnung kann vorteilhafterweise das Verfahren besonders stabil und zuverlässig ausgeführt werden. Die Wellenleiter-Anordnung kann eine definierte, räumliche Anordnung der Laser-Schreibstrahlen relativ zueinander herstellen und robust gegen Störungen aufrechterhalten. Jeder Wellenleiter kann dazu ausgebildet sein, den jeweiligen Laser-Schreibstrahl zu leiten oder zu führen. Jeder Wellenleiter kann als eine Hohlkernfaser oder als eine Massivkernfaser ausgebildet sein oder eine solche umfassen.

In einer Weiterbildung des Verfahrens weist jeder Wellenleiter ein erstes Ende und ein dem ersten Ende entgegengesetztes zweites Ende auf. Jedes erste Ende ist zum Einkoppeln eines Laser-Schreibstrahls eingerichtet und jedes zweite Ende ist zum Auskoppeln des in dem ersten Ende eingekoppelten Laser-Schreibstrahls eingerichtet. Die zweiten Enden der Mehrzahl von Wellenleitern sind von einer Haltematrix der Wellenleiter-Anordnung gehalten. Das Verfahren kann dabei ein Verlagern der Fokusse relativ zu der Lithografiematerial-Aufnahme mittels einer Verlagerung der Haltematrix vorsehen. Dabei können die Wellenleiter gegebenenfalls der Bewegung der Haltematrix folgen, beispielsweise durch entsprechende (elastische) Deformation, Biegen oder ähnliches. Das Verlagern der Fokusse relativ zu der Lithografiematerial-Aufnahme kann auch durch eine Verlagerung des Objektivs erfolgen oder unterstützt werden. Alternativ oder zusätzlich zu den vorgenannten Optionen kann ein Verlagern der Fokusse relativ zu der Lithografiematerial-Aufnahme durch eine Verlagerung der Lithografiematerial-Aufnahme und/oder Verlagern der Fokusse relativ zu der Lithografiematerial-Aufnahme mittels einer optischen Ablenkeinrichtung durch Ablenken der Laser-Schreibstrahlen erfolgen.

Das Vorsehen der Haltematrix ermöglicht ein besonders kompaktes und präzises Halten der zweiten Enden der Wellenleiter in einer definierten Anordnung zueinander.

Die Haltematrix kann aus Kunststoff, Harz, Glas oder Silizium geformt sein, in dem die zweiten Enden der Wellenleiter zumindest teilweise, insbesondere abschnittsweise, eingebettet sind.

Die Haltematrix kann ein Substrat mit präzisionsgefertigten V-förmigen Kerben zum Einlegen der Wellenleiter aufweisen. Alternativ kann die Haltematrix eine mikrostrukturierte Lochplatte aufweisen, wobei die Wellenleiter in Löcher der Lochplatte einsetzbar sind. Alternativ kann die Haltematrix eine Mehrzahl von Ferrulen aufweisen, wobei die Wellenleiter in die Ferrulen einsetzbar sind. Alternativ kann die Haltematrix eine Schweißverbindung zwischen den zweiten Enden der Wellenleiter der Wellenleiter-Anordnung sein.

Unter Verlagerung kann verstanden werden, dass eine Bewegung ausgeführt wird. Jede Verlagerung kann mittels eines Antriebs, insbesondere eines Linearantriebs und/oder eines Rotationsantriebs, erfolgen.

Die Verlagerung der Haltematrix kann mittels einer zu den Laser-Schreibstrahlen transversalen Bewegung und/oder einer zu den Laser-Schreibstrahlen longitudinalen Bewegung der Haltematrix erfolgen.

Während des Verlagerns der Fokusse relativ zu der Lithografiematerial-Aufnahme mittels einer Verlagerung der Haltematrix, kann das Objektiv ortsfest sein oder gemeinsam mit der Haltematrix verlagert werden. Eine Verlagerung der Haltematrix gemeinsam mit dem Objektiv kann bedeuten, dass die Haltematrix und das Objektiv simultan in eine gleiche Richtung und um eine gleiche Strecke verlagert werden. Das gemeinsame Verlagern der Haltematrix und des Objektivs kann z.B. mittels demselben Antrieb erfolgen.

Während dem Verlagern der Fokusse relativ zu der Lithografiematerial-Aufnahme mittels einer Verlagerung der Lithografiematerial-Aufnahme, kann die Haltematrix und/oder das Objektiv ortsfest sein.

Die optische Ablenkeinrichtung kann zwischen der Wellenleiter-Anordnung und dem Objektiv angeordnet sein. Die optische Ablenkeinrichtung kann einen Scannerspiegel, einen Spiegelgalvanometer, einen akustooptischen Deflektor, einen akustooptischen Modulator und/oder einen Membranspiegel zum Ablenken der Laser-Schreibstrahlen aufweisen.

In einer Weiterbildung des Verfahrens ist jeder Wellenleiter als eine optische Hohlkernfaser ausgebildet. Dadurch wird erreicht, dass eine unerwünschte Absorption deutlich reduziert wird und dass eine Zerstörungsschwelle der Wellenleiter wesentlich höher ist. Weiter kann jede Hohlkernfaser derart auf ihren zugeordneten Laser-Schreibstrahl abgestimmt sein, dass keine Pulsverbreiterung eines Laserpulses des Laser-Schreibstrahls nach dem Durchlaufen der Hohlkernfaser auftritt. Die optische Hohlkernfaser kann eine optische Faser sein, die einen hohlen Faserkern aufweist.

In einer Weiterbildung des Verfahrens ist jeder Wellenleiter ausgewählt aus der Gruppe umfassend: HC-PCF-Fasern, insbesondere HC-Kagome-Fasern, HC-PBGF-Fasern, HC-ARF-Fasern, HC-IC-Fasern, RH-Fasern, LMA-Fasern, PCF-Fasern.

Unter HC-PCF-Fasern können Hollow Core Photonic Crystal Fibers (deutsch: Photonische Kristallfasern mit hohlem Kern), unter HC-Kagome-Fasern können Hollow Core Kagome Fibers (deutsch: Hohlkern Kagome-Fasern), unter HC-PBGF-Fasern können Hollow Core Photonic Bandgap Fibers (deutsch: Photonische Bandlücken-Hohlkernfasern), unter HC-ARF-Fasern können Hollow Core Anti-Resonant Fibers (deutsch: Anti-Resonanz-Faser mit Hohlkern), unter HC-IC-Fasern können Hollow Core Inhibited Coupling Fibers (deutsch: Hohlkernfasern mit inhibierter Kopplung), unter RH-Fasern können Radiation Hardened Fibers (deutsch: Strahlungsharte Fasern oder strahlungsresistente Fasern), unter LMA-Fasern können Large Mode Area Fibers (deutsch: Fasern mit großer Modenfläche), unter PCF-Fasern können Photonic Crystal Fibers (deutsch: Photonische-Kristall-Fasern) verstanden werden.

Eine erfindungsgemäße Laserlithografie-Vorrichtung zum Erzeugen einer dreidimensionalen Struktur in einem Lithografiematerial. Insoweit Merkmale und Bauteile der Laserlithografie-Vorrichtung auch im Zusammenhang mit dem Verfahren beschrieben werden, gelten die dortigen Ausführungen entsprechend auch für die Laserlithografie-Vorrichtung. Die Vorrichtung weist eine Lithografiematerial-Aufnahme, eine Laserstrahlquelle, eine Demultiplexer-Einheit, ein Objektiv und eine Scan-Einrichtung auf. Die Lithografiematerial-Aufnahme ist zum Aufnehmen des Lithografiematerials ausgebildet. Die Laserstrahlquelle ist zum Erzeugen eines Eingangs-Laserstrahls ausgebildet. Die Demultiplexer-Einheit ist, insbesondere in Ausbreitungsrichtung des Eingangs-Laserstrahls, zwischen der Laserstrahlquelle und dem Objektiv angeordnet. Die Demultiplexer-Einheit ist dazu eingerichtet, den Eingangs-Laserstrahl durch Demultiplexen zeitlich in eine Mehrzahl von Laser-Schreibstrahlen aufzuteilen. Das Objektiv ist zur Fokussierung der Laser-Schreibstrahlen in jeweils einem dem Laser-Schreibstrahl zugeordneten Fokus ausgebildet. Die Scan-Einrichtung ist zur Verlagerung der Fokusse relativ zu der Lithografiematerial-Aufnahme ausgebildet.

Die Laserlithografie-Vorrichtung ist insbesondere dazu ausgebildet und konkret dazu ausgelegt, ein zuvor beschriebenes Verfahren auszuführen. Die zuvor gemachte Beschreibung zum Verfahren kann auch für gleiche oder funktional entsprechende Merkmale der Laserlithografie-Vorrichtung gelten.

Die Scan-Einrichtung kann eine zuvor beschriebene optische Ablenkeinrichtung zum Verlagern der Fokusse relativ zu der Lithografiematerial-Aufnahme durch Ablenken der Laser-Schreibstrahlen aufweisen. Die optische Ablenkeinrichtung der Scan-Einrichtung kann zwischen der Demultiplexer-Einheit und dem Objektiv angeordnet sein.

Zusätzlich oder alternativ kann die Scan-Einrichtung dazu ausgebildet sein, die Fokusse relativ zu der Lithografiematerial-Aufnahme mittels einer Verlagerung des Objektivs zu verlagern und/oder die Fokusse relativ zu der Lithografiematerial-Aufnahme mittels einer Verlagerung der Lithografiematerial-Aufnahme zu verlagern. Hierzu kann die Scan-Einrichtung Aktuatoren, insbesondere Stellmotoren oder Linearaktuatoren, vorzugsweise vibrierende Piezoaktuatoren, für das Verlagern umfassen.

Mit der Lithografiematerial-Aufnahme kann Lithografiematerial aufgenommen sein. Die Lithografie-Vorrichtung kann das Lithografiematerial auch umfassen.

In einer Weiterbildung der Laserlithografie-Vorrichtung ist die Laserstrahlquelle zum Erzeugen eines gepulsten Eingangs-Laserstrahls ausgebildet, der eine Mehrzahl von Laserpulsen aufweist. Die Demultiplexer-Einheit ist derart ausgebildet, dass das Demultiplexen durch ein Auskoppeln einer ersten Gruppe von Laserpulsen und wenigstens einer zweiten Gruppe von Laserpulsen aus dem gepulster Eingangs-Laserstrahl erfolgt. Die erste Gruppe von Laserpulsen bildet einen ersten Laser-Schreibstrahl und die zweite Gruppe von Laserpulsen bildet einen zweiten Laser-Schreibstrahl.

In einer Weiterbildung der Laserlithografie-Vorrichtung weist die Demultiplexer-Einheit eine Mehrzahl, insbesondere drei, vier oder fünf, von optischen Schaltern auf, die im Strahlengang des Eingangs-Laserstrahls in Reihe nacheinander angeordnet sind. Jeder optische Schalter ist in einer geschalteten Stellung dazu eingerichtet, einen jeweiligen Laser-Schreibstrahl durch Auskoppeln eines zum Überführen des Lithografiematerials in einem belichteten Zustand ausreichenden Laserstrahl-Anteils aus dem Eingangs-Laserstrahl zu bilden. In einer nicht geschalteten Stellung erfolgt dann insbesondere kein Auskoppeln eines Laser-Schreibstrahls. Jeder optische Schalter kann als ein faserintegrierter optischer Schalter ausgebildet sein.

Die optischen Schalter können in Ausbreitungsrichtung des Eingangs-Laserstrahls in Reihe nacheinander angeordnet sein. Die Mehrzahl von optischen Schaltern können gleich der Mehrzahl von Laser-Schreibstrahlen sein. Je ein optischer Schalter kann für das Bilden eines Laser-Schreibstrahls vorgesehen sein.

Jeder optische Schalter kann einen akustooptischen Modulator oder einen akustooptischen Deflektor zum Auskoppeln eines zum Überführen des Lithografiematerials in einem belichteten Zustand ausreichenden Laserstrahl-Anteils aus dem Eingangs-Laserstrahl aufweisen. Jeder optische Schalter kann einen Digitaleingang zum Überführen des optischen Schalters in die geschaltete Stellung aufweisen. An dem Digitaleingang kann ein Signal angelegt werden, um den optischen Schalter zwischen der geschalteten Stellung und einer nicht geschalteten Stellung überzuführen. Beispielsweise kann der optische Schalter die geschaltete Stellung aufweisen, wenn an dem Digitaleingang das Signal anliegt, und die nicht geschaltete Stellung aufweisen, wenn an dem Digitaleingang kein Signal anliegt.

Wenn der optische Schalter die nicht geschaltete Stellung aufweist, ist insbesondere vorgesehen, dass der Eingangs-Laserstrahl den optischen Schalter passieren kann, ohne dass dabei ein Laser-Schreibstrahl gebildet wird.

Denkbar ist, dass ein Auskoppelgrad eines jeden optischen Schalters, insbesondere stufenlos, einstellbar ist. Der Auskoppelgrad eines optischen Schalters kann ein Verhältnis der Leistung, insbesondere eine Peakleistung oder eine mittlere Leistung, des mit dem optischen Schalter gebildeten Laser-Schreibstrahls bezogen auf eine Leistung, insbesondere eine Peakleistung oder eine mittlere Leistung, des Eingangs-Laserstrahls vor dem optischen Schalter sein. In der nicht geschalteten Stellung kann der Auskoppelgrad 0% betragen. Mit anderen Worten, bei einem Auskoppelgrad von 0% kann der Eingangs-Laserstrahl den optischen Schalter passieren, ohne dass dabei ein Laser-Schreibstrahl gebildet wird. In der geschalteten Stellung kann der Auskoppelgrad beispielsweise 10%, 20%, 30%, 40%, 50%, 60%, 80%, 90% oder 95% betragen. Mit anderen Worten, eine Leistung des durch den optischen Schalter gebildeten Laser-Schreibstrahls beträgt 10%, 20%, 30%, 40%, 50%, 60%, 80%, 90% oder 95% der Leistung des Eingangs-Laserstrahls vor dem optischen Schalter, wenn dieser ununterbrochen die geschaltete Stellung aufweist.

Der optische Schalter kann einen Analogeingang aufweisen, an dem ein Signal zum Einstellen des Auskoppelgrads angelegt werden kann. Durch das Einstellen des Auskoppelgrads kann ein unterschiedlich starkes Belichten des Lithografiematerials erreicht werden.

In einer Weiterbildung der Laserlithografie-Vorrichtung weist die Demultiplexer-Einheit einen optischen Schalter auf, der im Strahlengang des Eingangs-Laserstrahls nach der Laserstrahlquelle angeordnet ist. Die Demultiplexer-Einheit weist eine optische Anordnung auf, die dazu eingerichtet ist, den Eingangs-Laserstrahl mehrmals über den optischen Schalter zu führen. Der optische Schalter ist in einer geschalteten Stellung dazu eingerichtet, einen Laser-Schreibstrahl durch Auskoppeln eines zum Überführen des Lithografiematerials in einem belichteten Zustand ausreichenden Laserstrahl-Anteils aus dem Eingangs-Laserstrahl zu bilden.

Die Demultiplexer-Einheit kann insbesondere einen einzigen optischen Schalter aufweisen. Die optische Anordnung kann dann dazu eingerichtet sein, den Eingangs-Laserstrahl zweimal, dreimal oder viermal über den optischen Schalter zu führen. Die optische Anordnung kann dazu eingerichtet sein, den Eingangs-Laserstrahl mehrmals mit unterschiedlichen Einfallswinkeln über den optischen Schalter zu führen. Die voranstehende Beschreibung eines optischen Schalters kann auch für den optischen Schalter gelten, über den der Eingangs-Laserstrahl mehrmals geführt ist.

In einer Weiterbildung der Laserlithografie-Vorrichtung weist die Laserlithografie-Vorrichtung eine Leistungserfassungseinheit zum Erfassen einer Leistung des Eingangs-Laserstrahls im Strahlengang nach der Demultiplexer-Einheit auf. Die Laserlithografie-Vorrichtung weist eine Steuereinheit auf, die dazu eingerichtet ist, die Demultiplexer-Einheit zum Zweck des Bildens der Mehrzahl von Laser-Schreibstrahlen durch Demultiplexen des Eingangs-Laserstrahls in Abhängigkeit der erfassten Leistung anzusteuern. Die Steuereinheit kann ein Computer oder eine Rechnereinheit sein.

Die Leistungserfassungseinheit kann eine Fotodiode oder ein Leistungsdetektor zum Erfassen der Leistung des Eingangs-Laserstrahls sein. Die Leistungserfassungseinheit kann derart angeordnet sein, dass die Leistungserfassungseinheit eine Leistung eines Reststrahls des Eingangs-Laserstrahls erfasst. Der Reststrahl kann kein Laser-Schreibstrahl sein. Der Reststrahl kann ein Laserstrahl sein, der von dem Eingangs-Laserstrahl nach dem Passieren der Demultiplexer-Einheit übrig ist. Die Leistung kann eine Leistung des Reststrahls sein.

In einer Weiterbildung der Laserlithografie-Vorrichtung weist die Laserlithografie-Vorrichtung eine Wellenleiter-Anordnung auf, die eine Mehrzahl von Wellenleitern zum Leiten der Mehrzahl von Laser-Schreibstrahlen aufweist. Je ein Wellenleiter ist einem Laser-Schreibstrahl zugeordnet. Die Wellenleiter im Strahlengang sind zwischen der Demultiplexer-Einheit und dem Objektiv angeordnet. Jeder Wellenleiter weist ein erstes Ende und ein dem ersten Ende entgegengesetztes zweites Ende auf. Jedes erste Ende ist zum Einkoppeln eines Laser-Schreibstrahls eingerichtet und jedes zweite Ende ist zum Auskoppeln des in dem ersten Ende eingekoppelten Laser-Schreibstrahls eingerichtet. Die zweiten Enden der Mehrzahl von Wellenleitern sind von einer Haltematrix der Wellenleiter-Anordnung gehalten. Innerhalb der Haltematrix können die Wellenleiter parallel und versetzt zueinander verlaufen. Jeder Wellenleiter kann als eine Hohlkernfaser oder als eine Massivkernfaser ausgebildet sein, oder eine entsprechende Faser umfassen.

Die zweiten Enden können in Ausbreitungsrichtung der aus den zweiten Enden ausgekoppelten Laser-Schreibstrahlen voneinander beabstandet sein. Mit anderen Worten, jedes zweite Ende der Mehrzahl von Wellenleitern kann eine Stirnfläche aufweisen, die dazu eingerichtet ist, den in dem ersten Ende eingekoppelten Laser-Schreibstrahl auszukoppeln, wobei die Stirnflächen der zweiten Enden in voneinander unterschiedlichen Ebene angeordnet sind. Anders formuliert, die zweiten Enden stehen unterschiedlich weit über. Vorteilhafterweise ermöglicht dies eine gleichzeitige Belichtung des Lithografiematerials in unterschiedlichen Ebenen. Dadurch kann eine Stabilität der dreidimensionalen Struktur während des Erzeugens oder Druckvorgangs erhöht werden. Zusätzlich kann dadurch die dreidimensionale Struktur schneller erzeugt werden. Insbesondere kann dies eine Realisierung einer höheren Packungsdichte der Fokusse ermöglichen.

In einer Weiterbildung der Laserlithografie-Vorrichtung sind die zweiten Enden der Mehrzahl von Wellenleitern von der Haltematrix in einer linearen Anordnung oder in einer zweidimensionalen Anordnung gehalten. Die lineare Anordnung und/oder die zweidimensionale Anordnung kann eine regelmäßige Anordnung sein.

Falls die zweiten Enden in der linearen Anordnung gehalten sind, können die zweiten Enden einen gleichen Abstand voneinander aufweisen. Falls die zweiten Enden in der zweidimensionalen Anordnung gehalten sind, können die zweiten Enden kristallstrukturartig angeordnet sein. Unter kristallstrukturartig kann verstanden werden, dass die zweiten Enden wie ein Punktgitter mit einem periodischen, sich wiederholenden Muster angeordnet sind.

In einer Weiterbildung der Laserlithografie-Vorrichtung beträgt der Abstand zwischen zwei benachbarten zweiten Enden der Mehrzahl von Wellenleitern 25 µm bis 1000 µm, insbesondere 115 µm bis 600 µm. Dadurch wird eine besonders kompakte Wellenleiter-Anordnung erzielt.

In einer Weiterbildung der Laserlithografie-Vorrichtung weist jedes zweite Ende der Mehrzahl von Wellenleitern eine Stirnfläche auf, die dazu eingerichtet ist, den in dem ersten Ende eingekoppelten Laser-Schreibstrahl auszukoppeln. Die Stirnflächen der zweiten Enden sind in einer Ebene angeordnet. Die Ebene kann senkrecht zu einer Ausbreitungsrichtung der ausgekoppelten Laser-Schreibstrahlen ausgerichtet sein.

In einer Weiterbildung der Laserlithografie-Vorrichtung ist die Scan-Einrichtung dazu eingerichtet, die Fokusse relativ zu der Lithografiematerial-Aufnahme mittels einer Verlagerung der Haltematrix zu verlagern. Hierzu kann die Scan-Einrichtung Aktuatoren, insbesondere Stellmotoren oder Linearaktuatoren, umfassen, die die Haltematrix verlagern.

In einer Weiterbildung der Laserlithografie-Vorrichtung ist jeder Wellenleiter als eine optische Hohlkernfaser ausgebildet.

In einer Weiterbildung der Laserlithografie-Vorrichtung ist jeder Wellenleiter ausgewählt aus der Gruppe umfassend: HC-PCF-Fasern, insbesondere HC-Kagome-Fasern, HC-PBGF-Fasern, HC-ARF-Fasern, HC-IC-Fasern, RH-Fasern, LMA-Fasern, PCF-Fasern.

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Gleiche und funktional entsprechende Elemente sind mit identischen Bezugszeichen versehen. Dabei zeigen:
- Fig. 1: eine schematische Ansicht einer Laserlithografie-Vorrichtung,
- Fig. 2: eine schematische Darstellung eines Betriebs einer Demultiplexer-Einheit der Laserlithografie-Vorrichtung,
- Fig. 3: eine schematische Ansicht auf eine Stirnseite einer Wellenleiter-Anordnung der Laserlithografie-Vorrichtung,
- Fig. 4: eine schematische Ansicht von Fig. 3 auf eine Variante der Wellenleiter-Anordnung,
- Fig. 5: eine schematische Darstellung von Fokusse der Laser-Schreibstrahlen in einer Fokusebene,
- Fig. 6: eine schematische Darstellung der Fokusse von Fig. 5 in einer zur Fokusebene orthogonalen Ebene, und
- Fig. 7: eine schematische Ansicht von Fig. 1 einer Variante der Laserlithografie-Vorrichtung.

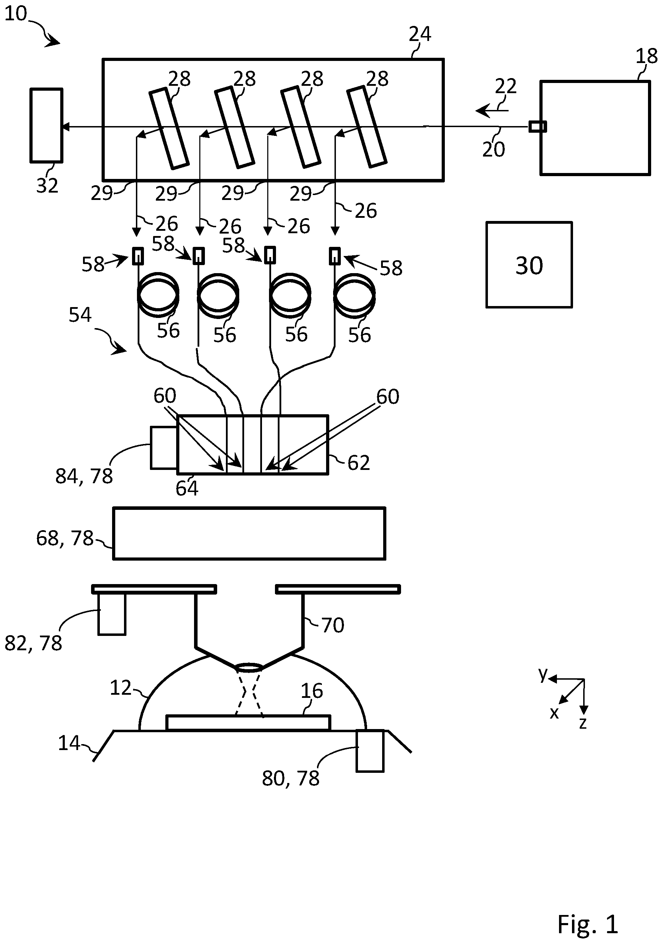

Fig. 1 zeigt eine Laserlithografie-Vorrichtung 10 zum Erzeugen einer dreidimensionalen Struktur in einem Lithografiematerial 12 mittels Multi-Photonen-Polymerisation.

Die Laserlithografie-Vorrichtung 10 hat eine Lithografiematerial-Aufnahme 14. Die Lithografiematerial-Aufnahme 14 ist als Tisch in Form eines Maschinentisches ausgebildet. Auf der Lithografiematerial-Aufnahme 14 ist ein Substrat 16 in Form eines Wafers platziert, auf dem die dreidimensionale Struktur erzeugt werden soll.

Auf der Lithografiematerial-Aufnahme 14 und auf dem Substrat 16 liegt das Lithografiematerial 12 tropfenförmig auf. In Fig. 1 ist dargestellt, dass das Lithografiematerial 12 die Lithografiematerial-Aufnahme 14 und das Substrat 16 kontaktiert. In einem alternativen, nicht gezeigten Ausführungsbeispiel kontaktiert das Lithografiematerial nur das Substrat. In beiden Fällen ist die Lithografiematerial-Aufnahme 14 dazu ausgebildet, das Lithografiematerial 12 zum Zweck des Herstellens der dreidimensionalen Struktur aufzunehmen.

Die Laserlithografie-Vorrichtung 10 hat eine Laserstrahlquelle 18 für das Erzeugen eines Eingangs-Laserstrahls 20. Der Eingangs-Laserstrahl 20 breitet sich in einer Ausbreitungsrichtung 22 aus.

Der Eingangs-Laserstrahl 20 ist ein gepulster Laserstrahl, der eine Mehrzahl von Laserpulsen aufweist. Ein Laserpuls des gepulsten Eingangs-Laserstrahls 20 hat eine Pulsdauer von 250 Femtosekunden. Die Laserpulse des gepulsten Eingangs-Laserstrahls 20 weisen eine Repetitionsrate von 80 MHz auf.

Die Laserlithografie-Vorrichtung 10 hat eine Demultiplexer-Einheit 24. Die Demultiplexer-Einheit 24 ist in Ausbreitungsrichtung 22 des Eingangs-Laserstrahls 20 nach der Laserstrahlquelle 18 angeordnet. Die Demultiplexer-Einheit 24 ist dazu eingerichtet, den Eingangs-Laserstrahl 20 durch Demultiplexen zeitlich und räumlich in eine Mehrzahl von Laser-Schreibstrahlen 26 aufzuteilen.

Jeder Laser-Schreibstrahl 26 breitet sich entlang einer Strahlachse aus. Die Strahlachse ist eine Längsachse des jeweiligen Laser-Schreibstrahls 26, die sich in Richtung seiner Ausbreitungsrichtung erstreckt. Die Strahlachsen der Laser-Schreibstrahlen 26 unterscheiden sich voneinander. Die Strahlachsen der Laser-Schreibstrahlen 26 sind zueinander parallel und versetzt orientiert. Die Strahlachsen der Laser-Schreibstrahlen 26 und eine Strahlachse des Eingangs-Laserstrahls 20 sind zueinander orthogonal orientiert. Mit anderen Worten, die Strahlachsen Laser-Schreibstrahlen 26 verlaufen nicht kollinear zu der Strahlachse des Laserstrahls 20.

In dem dargestellten Beispiel der Fig. 1 wird der Eingangs-Laserstrahl 20 durch die Demultiplexer-Einheit 24 in insgesamt vier Laser-Schreibstrahlen 26 aufgeteilt. Hierzu hat die Demultiplexer-Einheit 24 insgesamt vier optische Schalter 28, die Ausbreitungsrichtung 22 in Reihe nacheinander angeordnet sind. Mit anderen Worten, in einer nicht geschalteten Stellung der optischen Schalter 28 kann der Eingangs-Laserstrahl 20 unbeeinflusst von den optischen Schaltern 28 diese nacheinander passieren.

Je ein optischer Schalter 28 ist für das Bilden eines Laser-Schreibstrahls 26 vorgesehen. Jeder optische Schalter 28 ist in einer geschalteten Stellung dazu eingerichtet, einen jeweiligen Laser-Schreibstrahl 26 aus dem Eingangs-Laserstrahl 20 zu bilden. Jeder optischer Schalter 28 ist als ein akustooptischer Modulator ausgebildet. Das Bilden der Laser-Schreibstrahlen 26 erfolgt durch Auskoppeln eines zum Verfestigen des Lithografiematerials 12 ausreichenden Laserstrahl-Anteils aus dem Eingangs-Laserstrahl 20. Mit anderen Worten, das Demultiplexen ist ein Richten oder Lenken des ausreichenden Laserstrahl-Anteils auf einen von mehreren Ausgängen 29 der Demultiplexer-Einheit 24. In dem dargestellten Ausführungsbeispiel erfolgt dies mittels den optischen Schaltern 28 und der Einfachheit halber nicht dargestellten Umlenkspiegeln.

Insgesamt hat die Demultiplexer-Einheit 24 vier Ausgänge 29. Die Anzahl der Ausgänge 29 ist gleich der Anzahl der Laser-Schreibstrahlen 26, die mittels der Demultiplexer-Einheit 24 gebildet werden. Ein auf einen Ausgang 29 gerichteter oder gelenkter ausreichender Laserstrahl-Anteil bildet nach dem Passieren des Ausgangs 26 einen Laser-Schreibstrahl 26.

Um die vier Laser-Schreibstrahlen 26 mittels der Demultiplexer-Einheit 24 zu bilden, wird nacheinander ein optischer Schalter 28 in die geschaltete Stellung überführt, der daraufhin einen ausreichende Laserstrahl-Anteil aus dem Eingangs-Laserstrahl 20 ausgekoppelt und auf den zugehörigen Ausgang 29 richtet.

Jeder optische Schalter 28 hat einen Digitaleingang zum Überführen des optischen Schalters zwischen der nicht geschalteten Stellung und der geschalteten Stellung. Das Überführen in die geschaltete Stellung oder in die nicht geschaltete Stellung erfolgt mittels eines Signals, das an den Digitaleingang angelegt wird. In dem dargestellten Beispiel befindet sich der optische Schalter 28 in der geschalteten Stellung, wenn an dem Digitaleingang ein Signal anliegt, und in der nicht geschalteten Stellung, wenn an dem Digitaleingang kein Signal anliegt.

Die Laserlithografie-Vorrichtung 10 hat eine Steuereinheit 30, die dazu eingerichtet ist, die Demultiplexer-Einheit 24 zum Zweck des Bildens der Laser-Schreibstrahlen 26 durch Demultiplexen des Eingangs-Laserstrahls 20 anzusteuern. Die optischen Schalter 28 werden durch die Steuereinheit 30 nacheinander in die geschaltete Stellung überführt. Hierzu legt die Steuereinheit 30 an den Digitaleingängen der einzelnen optischen Schalter 28 nacheinander ein Signal an.

Die Laserlithografie-Vorrichtung 10 hat eine Leistungserfassungseinheit 32 in Form eines Leistungsdetektors zum Erfassen einer Leistung des Eingangs-Laserstrahls 20 nach der Demultiplexer-Einheit 24. Damit erfasst die Leistungserfassungseinheit 32 die Leistung des Eingangs-Laserstrahls 20, die von dem Eingangs-Laserstrahl 20 nach dem Passieren der Demultiplexer-Einheit 24 übrig ist. In dem dargestellten Beispiel der Fig. 1 ist die Leistungserfassungseinheit 32 derart angeordnet, dass, wenn die optischen Schalter 28 in der nicht geschalteten Stellung sind und der Eingangs-Laserstrahl 20 unbeeinflusst von den optischen Schaltern 28 diese nacheinander passiert, der Eingangs-Laserstrahl 20 auf die Leistungserfassungseinheit 32 trifft. Die Leistungserfassungseinheit 32 erfasst eine Leistung des Eingangs-Laserstrahls 20, die gleich einer Leistung des Eingangs-Laserstrahls 20 vor der Demultiplexer-Einheit 24 ist.

Falls einer der optischen Schalter 28 in der geschalteten Stellung ist und dabei beispielsweise 80% der Peakleistung des Eingangs-Laserstrahls 20 zum Bilden eines Laser-Schreibstrahls 26 ausgekoppelt, dann erfasst die Leistungserfassungseinheit 32 eine Leistung des Eingangs-Laserstrahls 20, wobei die Peakleistung des auf die Leistungserfassungseinheit 32 auftreffenden Eingangs-Laserstrahls 20 20% der Peakleistung des Eingangs-Laserstrahls 20 vor der Demultiplexer-Einheit 24 beträgt.

Die Steuereinheit 30 ist dazu eingerichtet, die Demultiplexer-Einheit 24 in Abhängigkeit der mit der Leistungserfassungseinheit 32 erfassten Leistung anzusteuern.

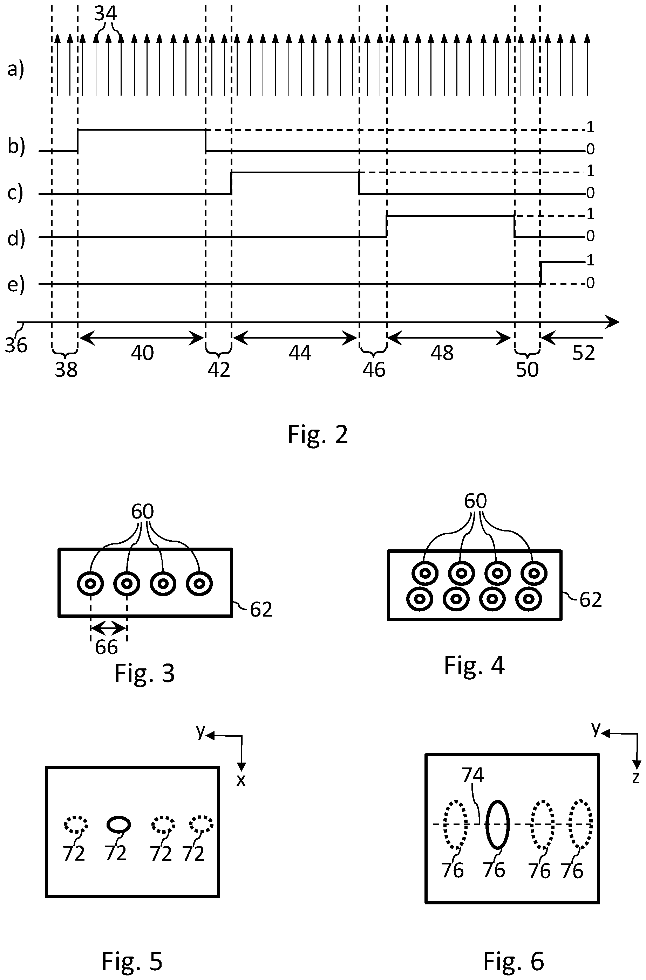

Ein Beispiel für einen Betrieb der Demultiplexer-Einheit 24 ist in Fig. 2 gezeigt.

In Fig. 2 a) sind einzelne Laserpulse 34 des gepulsten Eingangs-Laserstrahls 20 vor der Demultiplexer-Einheit 24 über eine Zeitachse 36 in Form von Pfeilen dargestellt. In Fig. 2 b) bis e) ist jeweils ein zeitlicher Verlauf eines Signales, welche die Steuereinheit 30 an den Digitaleingang des jeweiligen optischen Schalters 28 anlegt, über die Zeitachse 36 dargestellt. Wenn das Signal den Wert 1 hat, nimmt der jeweilige optische Schalter 28 die geschaltete Stellung ein, und wenn das Signal den Wert 0 hat, nimmt der jeweilige optische Schalter 28 die nicht geschaltete Stellung ein.

Die Steuereinheit 30 ist dazu eingerichtet, an den Digitaleingängen der optischen Schaltern 28 nacheinander Signale für eine vorgegebene Dauer anzulegen. Die vorgegebene Dauer ist z.B. für alle optischen Schalter 28 gleich. Die vorgegebene Dauer ist im Ausführungsbeispiel der Fig. 2 derart gewählt, dass jeder optische Schalter 28 zehn Laserpulse 34 aus dem Eingangs-Laserstrahl 20 ausgekoppelt. Mit anderen Worten, die Steuereinheit 30 ist dazu eingerichtet, Signale für eine Dauer von zehn Laserpulsen 34 an den Digitaleingängen der optischen Schaltern 28 anzulegen. Die vorgegebene Dauer kann aber auch anders gewählt sein, so dass mehr oder weniger Laserpulse 34 ausgekoppelt werden. Die ausgekoppelten Laserpulse 34 bilden zumindest teilweise die Laser-Schreibstrahlen 26.

Zwischen zwei nacheinander an den optischen Schaltern 28 angelegten Signalen liegt für einen vorgegebenen Zeitabschnitt kein Signal an den optischen Schalter 28 an. Der vorgegebene Zeitabschnitt ist im Ausführungsbeispiel der Fig. 2 derart gewählt, dass zwischen den ausgekoppelten Laserpulsen 34 jeweils zwei Laserpulse 34 nicht durch die optischen Schalter 28 ausgekoppelt werden. Die nicht ausgekoppelten Laserpulse 34 gelangen auf die Leistungserfassungseinheit 32. Der vorgegebene Zeitabschnitt kann aber auch anders gewählt sein, so dass mehr oder weniger Laserpulse auf die Leistungserfassungseinheit 32 gelangen.

Im Detail zeigt Fig. 2, dass zwei Laserpulse 34 eines Zeitabschnitts 38 auf die Leistungserfassungseinheit 32 gelangen. Die Steuereinheit 30 legt das in Fig. 2 b) dargestellte Signal an einen ersten optischen Schalter 28 für einen Zeitabschnitt 40 an, der zehn Laserpulse 34 beinhaltet. Die mittels des ersten optischen Schalters 28 ausgekoppelten zehn Laserpulse 34 bilden zumindest teilweise einen ersten Laser-Schreibstrahl 26. Anschließend gelangen zwei Laserpulse 34 eines Zeitabschnitts 42 auf die Leistungserfassungseinheit 32. Die Steuereinheit 30 legt das in Fig. 2 c) dargestellte Signal an einen zweiten optischen Schalter 28 für einen Zeitabschnitt 44 an, der zehn Laserpulse 34 beinhaltet. Die mittels des zweiten optischen Schalters 28 ausgekoppelten zehn Laserpulse 34 bilden zumindest teilweise einen zweiten Laser-Schreibstrahl 26. Anschließend gelangen die zwei Laserpulse 34 eines Zeitabschnitts 46 auf die Leistungserfassungseinheit 32. Die Steuereinheit 30 legt das in Fig. 2 d) dargestellte Signal an einen dritten optischen Schalter 28 für einen Zeitabschnitt 48 an, der zehn Laserpulse 34 beinhaltet. Die mittels des dritten optischen Schalters 28 ausgekoppelten zehn Laserpulse 34 bilden zumindest teilweise einen dritten Laser-Schreibstrahl 26. Anschließend gelangen die zwei Laserpulse 34 des Zeitabschnitts 50 auf die Leistungserfassungseinheit 32. Die Steuereinheit 30 legt das in Fig. 2 e) dargestellte Signal an einen vierten optischen Schalter 28 für einen Zeitabschnitt 52 an, der zehn Laserpulse 34 beinhaltet. Die mittels des vierten optischen Schalters 28 ausgekoppelten zehn Laserpulse 34 bilden zumindest teilweise einen vierten Laser-Schreibstrahl 26. Mit den nachfolgenden zwei Laserpulsen 34 beginnt die Abfolge des Anlegens des Signals an die optischen Schalter 28 von vorne.

Ein Kalibrieren der optischen Schalter 28, insbesondere ein Kalibrieren der zeitlichen Versätze zum Betrieb der optischen Schalter 28, erfolgt durch Anlegen eines periodischen Signals jeweils an zwei optischen Schalter 28, wohingegen an den übrigen optischen Schalter 28 kein Signal angelegt wird. Danach wird ein zeitlicher Versatz zwischen den beiden periodischen Signalen verändert und gleichzeitig die mittlere Leistung mittels der Leistungserfassungseinheit 32 erfasst. Dabei wird an der Leistungserfassungseinheit 32 eine maximale mittlere Leistung erfasst, wenn die beiden optischen Schalter 28 gleichzeitig die geschaltete Stellung aufweisen. Anhand des zeitlichen Versatzes dieses Zustands lässt sich ermitteln, bei welchem zeitlichen Versatz der in Fig.2 dargestellte Betriebszustand für diese beiden optischen Schalter 28 eintritt. Ein Kalibrieren der übrigen optischen Schalter 28 erfolgt entsprechend.

Die Demultiplexer-Einheit 24 ist derart ausgebildet, dass das Demultiplexen durch ein Auskoppeln von Gruppen von Laserpulsen aus dem gepulster Eingangs-Laserstrahl 20 erfolgt. Die Gruppen von Laserpulsen bilden die Laser-Schreibstrahlen 26. Anders formuliert, die Demultiplexer-Einheit 24 bildet die Laser-Schreibstrahl 26 durch Puls-Picking. Die Laser-Schreibstrahl 26 werden durch zeitliches und räumliches Aufteilen der Laserpulse 34 des Eingangs-Laserstrahls 20 gebildet.

Die optischen Schalter 28 haben jeweils einen Analogeingang, an dem ein Signal zum Einstellen eines Auskoppelgrads angelegt werden kann. Ein Auskoppelgrad eines jeden optischen Schalters 28 ist stufenlos einstellbar. Der Auskoppelgrad ist ein Verhältnis der Peakleistung eines mit einem optischen Schalter 28 gebildeten Laser-Schreibstrahls 26 bezogen auf eine Peakleistung des Eingangs-Laserstrahls 20 vor dem optischen Schalter 28.

Die Steuereinheit 30 ist dazu eingerichtet, ein Signal zum Einstellen des Auskoppelgrads an den jeweiligen optischen Schalter 28 anzulegen. In dem dargestellten Beispiel legt die Steuereinheit 30 derart ein Signal an den Analogeingang an, dass der Auskoppelgrad 80% beträgt. Mit anderen Worten, eine Spitzenleistung der von den optischen Schaltern 28 ausgekoppelten Laserpulse ist um 20% im Vergleich zu der Spitzenleistung der Laserpulse des Eingangs-Laserstrahls 20 reduziert.

Die Laserlithografie-Vorrichtung 10 hat eine Wellenleiter-Anordnung 54, siehe Fig. 1. die Wellenleiter-Anordnung 54 hat eine Mehrzahl von Wellenleitern 56 zum Leiten der Mehrzahl von Laser-Schreibstrahlen 26. Je ein Wellenleiter 56 ist einem Laser-Schreibstrahl 26 zugeordnet.

Die Wellenleiter 56 sind im Strahlengang nach der Demultiplexer-Einheit 24 angeordnet. Jeder Wellenleiter 56 ist eine optische Hohlkernfaser, nämlich eine Hollow Core Photonic Crystal Fibers (deutsch: Photonische Kristallfasern mit hohlem Kern). Jeder Wellenleiter 56 ist dazu ausgebildet, den dem Wellenleiter 56 zugeordneten Laser-Schreibstrahl 26 zu leiten oder zu führen.

Jeder Wellenleiter 56 hat ein erstes Ende 58 und ein dem ersten Ende entgegengesetztes zweites Ende 60. Jedes erste Ende 58 ist zum Einkoppeln des dem Wellenleiter 56 zugeordneten Laser-Schreibstrahls 26 eingerichtet. Die Laser-Schreibstrahlen 26 werden über eine Freistrahleinkopplung in die Wellenleiter 56 eingekoppelt. Jedes zweite Ende 60 hat eine Stirnfläche, die dazu eingerichtet ist, den in dem ersten Ende 58 eingekoppelten Laser-Schreibstrahl 26 auszukoppeln. Damit ist jedes zweite Ende 60 zum Auskoppeln des in dem ersten Ende 58 eingekoppelten Laser-Schreibstrahls 26 eingerichtet.

Die zweiten Enden 60 sind von einer Haltematrix 62 der Wellenleiter-Anordnung 54 gehalten. Innerhalb der Haltematrix 62 verlaufen die Wellenleiter 56 parallel und versetzt zueinander. In dem dargestellten Beispiel weist die Haltematrix 62 ein Substrat mit präzisionsgefertigten, parallel verlaufenden V-förmigen Kerben auf. Das Substrat kann beispielsweise aus Kunststoff, Harz, Glas oder Silizium geformt sein. In die Kerben werden die Wellenleiter 56 eingelegt. Freiräume zwischen den Wellenleitern 56 und dem Substrat sind mit für Optik geeignetem Klebstoff, beispielsweise in Form von UV-Kleber, gefüllt. Ein Deckel der Haltematrix 62 wird aufgeklebt, der die Wellenleiter 56 in die V-förmigen Kerben drückt.

Die Stirnflächen der zweiten Enden 60 sind in einer Ebene angeordnet. Die Ebene und die Stirnflächen 64 sind senkrecht zu einer Ausbreitungsrichtung der ausgekoppelten Laser-Schreibstrahlen 26 ausgerichtet.

Fig. 3 zeigt eine schematische Darstellung der Stirnfläche 64 der Wellenleiter-Anordnung 54. Die zweiten Enden 60 der Wellenleitern 56 sind von der Haltematrix 62 in einer regelmäßigen linearen Anordnung gehalten. Mit anderen Worten, die zweiten Enden 60 haben einen gleichen Abstand 66 voneinander. Der Abstand 66 zwischen zwei benachbarten zweiten Enden 60 beträgt 250 µm.

Fig. 4 zeigt ein weiteres Ausführungsbeispiel der Wellenleiter-Anordnung 54 der Fig. 3, die für eine Verwendung mit bis zu acht Laser-Schreibstrahlen geeignet ist. Für identische und funktionell äquivalente Elemente sind gleiche Bezugszeichen verwendet und insoweit kann auf die obigen Ausführungen zum Ausführungsbeispiel der Fig. 3 verwiesen werden, so dass im Wesentlichen nur auf die bestehenden Unterschiede eingegangen wird.

Die zweiten Enden 60 der Wellenleiter-Anordnung 54 der Fig. 4 sind von der Haltematrix 62 in einer regelmäßigen zweidimensionalen Anordnung gehalten. Die zweiten Enden 60 sind kristallstrukturartig angeordnet. Mit anderen Worten, die zweiten Enden 60 sind mit einem periodischen, sich wiederholenden Muster angeordnet.

Fig. 1 zeigt, dass die Lithografie-Vorrichtung 10 in dem Strahlengang der Laser-Schreibstrahlen 26 nach der Wellenleiter-Anordnung 54 eine optische Ablenkeinrichtung 68 in Form eines Spiegelgalvanometers und ein Objektiv 70 aufweist. Die optische Ablenkeinrichtung 68 ist zum Ablenken der Laser-Schreibstrahlen 26 und das Objektiv 70 ist zur Fokussierung der Laser-Schreibstrahlen 26 ausgebildet.

Das Objektiv 70 ist in das Lithografiematerial 12 eingetaucht. Das Objektiv 70 fokussiert die Laser-Schreibstrahlen 26 zum Zweck des Erzeugens der dreidimensionalen Struktur in das Lithografiematerial 12. Die Fokusse der Laser-Schreibstrahlen 26 liegen alle in einer Fokusebene.

Fig. 5 ist eine schematische Darstellung einer Ansicht auf die Fokusebene und die einzelnen Fokusse 72. Durch das Demultiplexen des Eingangs-Laserstrahls 20 bilden sich innerhalb des Lithografiematerials 12 zeitlich und räumlich getrennt voneinander die Fokusse 72 aus. Dies ist in Fig. 5 durch die gestrichelte und durchgezogene Darstellung der Fokusse 72 verdeutlicht.

Fig. 6 ist eine schematische Darstellung der Fokusse 72 von Fig. 5 in einer zur Fokusebene 74 orthogonalen Ebene. Dargestellt sind Bereiche 76 um die Fokusse der Laser-Schreibstrahlen, in denen sich das Lithografiematerial 12 mittels Multiphotonen-Polymerisation verfestigt. Somit weisen die durch das Demultiplexen gebildeten Laser-Schreibstrahlen 26 ein zum Verfestigen des Lithografiematerials 12 ausreichenden Laserstrahl-Anteil aus dem Eingangs-Laserstrahl 20 auf.

Fig. 1 zeigt, dass die Lithografie-Vorrichtung 10 eine Scan-Einrichtung 78 zum Verlagern der Fokusse 72 relativ zu der Lithografiematerial-Aufnahme 14 hat. Die Scan-Einrichtung 78 weist die optische Ablenkeinrichtung 68 auf. Des Weiteren hat die Scan-Einrichtung 78 einen Aktuator 80, der an der Lithografiematerial-Aufnahme 14 angeordnet ist, einen Aktuator 82, der an dem Objektiv 70 angeordnet ist, und einen Aktuator 84, der an der Haltematrix 62 angeordnet ist. Jeder Aktuator 80, 82, 84 ist ein Linearaktuator in Form eines Piezoaktuators. In einem alternativen, nicht gezeigten Ausführungsbeispiel sind auch andere Aktuator-Typen denkbar.

In einem alternativen, nicht gezeigten Ausführungsbeispiel kann die Lithografie-Vorrichtung 10 zumindest einen Aktuator von den Aktuatoren 80, 82, 84 aufweisen.

Durch den an der Lithografiematerial-Aufnahme 14 angeordneten Aktuator 80, kann die Scan-Einrichtung 78 die Fokusse 72 relativ zu der Lithografiematerial-Aufnahme 14 durch eine Verlagerung der Lithografiematerial-Aufnahme 14 verlagern. Durch den an dem Objektiv 70 angeordneten Aktuator 82, kann die Scan-Einrichtung 78 die Fokusse 72 relativ zu der Lithografiematerial-Aufnahme 14 durch eine Verlagerung des Objektivs 70 verlagern. Durch den an der Haltematrix 62 angeordneten Aktuator 84, kann die Scan-Einrichtung 78 die Fokusse 72 relativ zu der Lithografiematerial-Aufnahme 14 durch eine Verlagerung der Haltematrix 62 verlagern. Durch die optische Ablenkeinrichtung 68 kann die Scan-Einrichtung 78 die Fokusse 72 relativ zu der Lithografiematerial-Aufnahme 14 durch eine Ablenkung der Laser-Schreibstrahlen 26 verlagern.

Die Laserlithografie-Vorrichtung 10 ist dazu ausgebildet, ein Verfahren zum Erzeugen einer dreidimensionalen Struktur in dem Lithografiematerial 12 auszuführen. Das Verfahren weist die Schritte auf: Aufnehmen des Lithografiematerials 12 mittels der Lithografiematerial-Aufnahme 14; Erzeugen des Eingangs-Laserstrahls 20 mittels der Laserstrahlquelle 18; Bilden von vier Laser-Schreibstrahlen 26 durch Demultiplexen des Eingangs-Laserstrahls 20 mittels einer Demultiplexer-Einheit 62, die zwischen der Laserstrahlquelle 18 und dem Objektiv 70 angeordnet ist; Einkoppeln der Mehrzahl von Laser-Schreibstrahlen 26 in eine Wellenleiter-Anordnung 54, die eine Mehrzahl von Wellenleitern 56 aufweist; Eintauchen des Objektivs in das Lithografiematerial; Fokussieren der Mehrzahl von Laser-Schreibstrahlen 26 mittels des Objektivs 70 in das Lithografiematerial 12; Erzeugen der dreidimensionalen Struktur in dem Lithografiematerial 12 mittels der fokussierten Laser-Schreibstrahlen 26 durch Multi-Photonen-Polymerisation.

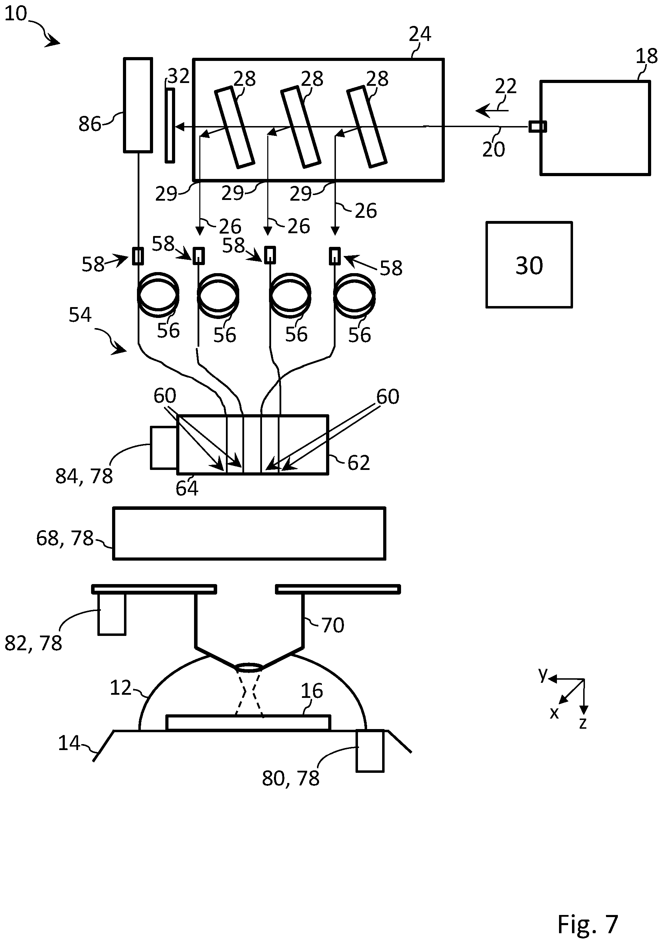

Fig. 7 zeigt ein weiteres Ausführungsbeispiel der Laserlithografie-Vorrichtung 10 von Fig. 1, wobei für identische und funktionell äquivalente Elemente gleiche Bezugszeichen verwendet sind und insoweit auf die obigen Ausführungen zum Ausführungsbeispiel der Fig. 1 verwiesen werden kann, so dass im Wesentlichen nur auf die bestehenden Unterschiede eingegangen wird.

Die Laserlithografie-Vorrichtung 10 verfügt über eine zusätzliche Laserstrahlquelle 86. Die zusätzliche Laserstrahlquelle 86 ist zur Erzeugung eines Dauerstrich-Laserstrahls ausgebildet.

In einem alternativen, nicht gezeigten Ausführungsbeispiel kann die zusätzliche Laserstrahlquelle zur Erzeugung eines gepulsten Laserstrahls ausgebildet sein.

Im Ausführungsbeispiel der Fig. 7 ist die zusätzliche Laserstrahlquelle 86 mit einem Wellenleiter 56 der Wellenleiter-Anordnung 54 gekoppelt. Mit anderen Worten, die zusätzliche Laserstrahlquelle 86 stellt ihren erzeugten Laserstrahl an einem Faserausgang bereit, der an das erste Ende eines Wellenleiters 56 der Wellenleiter-Anordnung 54 eingekoppelt wird. Zum Einkoppeln der erzeugten Laserstrahlung kann der Faserausgang an das erste Ende des Wellenleiters 56 aneinander gespleißt sein. Alternativ kann der Faserausgang und das erste Ende des Wellenleiters 56 von einem Koppler zum Zweck des Einkoppelns der erzeugten Laserstrahlung in das erste Ende gehalten sein.

Die zusätzliche Laserstrahlquelle 86 kann eine integrierte Leistungsmodulation aufweisen. Die integrierte Leistungsmodulation kann beispielsweise mittels eines integrierten akustooptischen Modulators ausgeführt sein. Alternativ kann die zusätzliche Leistungsstrahlquelle 86 durch elektrische Schalten, beispielsweise durch abwechselndes Ein- und Ausschalten, in ihrer Leistung moduliert sein. Alternativ kann die zusätzliche Leistungsstrahlquelle 86 durch direkte Modulation, beispielsweise durch elektrisches Schalten des Versorgungsstroms, moduliert sein.

Die Demultiplexer-Einheit 24 der Laserlithografie-Vorrichtung 10 der Fig. 7 hat drei optische Schalter 28, die jeweils einen Laser-Schreibstrahl 26 durch Demultiplexen des Eingangs-Laserstrahls 20 erzeugen. Die drei Laser-Schreibstrahlen 26 werden in die übrigen drei Wellenleitern 56 der Wellenleiter-Anordnung 54 über eine Freistrahleinkopplung eingekoppelt.

## Patentansprüche

1. Verfahren zum Erzeugen einer dreidimensionalen Struktur in einem Lithografiematerial (12), wobei das Verfahren die folgenden Schritte aufweist:
- Aufnehmen des Lithografiematerials (12) mittels einer Lithografiematerial-Aufnahme (14),
- Erzeugen eines Eingangs-Laserstrahls (20) mittels einer Laserstrahlquelle (18),
- Demultiplexen des Eingangs-Laserstrahls (20) zur Ausbildung einer Mehrzahl von Laser-Schreibstrahlen (26) durch zeitliches Aufteilen des Eingangs-Laserstrahls (20),
- Fokussieren der Laser-Schreibstrahlen (26) mittels eines Objektivs (70),
- Erzeugen der dreidimensionalen Struktur in dem Lithografiematerial (12) mittels der fokussierten Laser-Schreibstrahlen (26).

2. Verfahren nach Anspruch 1,
- wobei jeder Laser-Schreibstrahl (26) durch Auskoppeln eines zum Überführen des Lithografiematerials (12) in einen belichteten Zustand ausreichenden Laserstrahl-Anteils aus dem Eingangs-Laserstrahl (20) gebildet wird.

3. Verfahren nach Anspruch 1 oder 2,
- wobei der Eingangs-Laserstrahl (20) ein gepulster Laserstrahl ist, der eine Mehrzahl von Laserpulsen (34) aufweist,
- wobei das Demultiplexen des Eingangs-Laserstrahls (20) durch ein Auskoppeln einer ersten Gruppe von Laserpulsen (34) und wenigstens einer zweiten Gruppe von Laserpulsen (34) aus dem gepulsten Eingangs-Laserstrahl (20) derart erfolgt,
- dass die erste Gruppe von Laserpulsen (34) einen ersten Laser-Schreibstrahl bildet und die zweite Gruppe von Laserpulsen (34) einen zweiten Laser-Schreibstrahl bildet.

4. Verfahren nach einem der voranstehenden Ansprüche,
- wobei das Verfahren den Schritt aufweist:
- Erfassen einer Leistung des Eingangs-Laserstrahls (20) im Strahlengang des Eingangs-Laserstrahls (20) nach dem Demultiplexen, wobei das Bilden der Mehrzahl von Laser-Schreibstrahlen (26) in Abhängigkeit der erfassten Leistung erfolgt.

5. Verfahren nach einem der voranstehenden Ansprüche,
- wobei das Verfahren den Schritt aufweist:
- Einkoppeln der Mehrzahl von Laser-Schreibstrahlen (26) in eine Wellenleiter-Anordnung (54), die eine Mehrzahl von Wellenleitern (56) aufweist, wobei je ein Wellenleiter (56) einem Laser-Schreibstrahl (26) zugeordnet ist, und wobei die Wellenleiter (56) im Strahlengang zwischen der Laserstrahlquelle (18) und dem Objektiv (70) angeordnet sind.

6. Verfahren nach Anspruch 5,
- wobei jeder Wellenleiter (56) ein erstes Ende (58) und ein dem ersten Ende (58) entgegengesetztes zweites Ende (60) aufweist,
- wobei jedes erste Ende (58) zum Einkoppeln eines Laser-Schreibstrahls (26) eingerichtet ist und jedes zweite Ende (60) zum Auskoppeln des in dem ersten Ende (58) eingekoppelten Laser-Schreibstrahls (26) eingerichtet ist,
- wobei die zweiten Enden (60) der Mehrzahl von Wellenleitern (56) von einer Haltematrix (62) der Wellenleiter-Anordnung (54) gehalten sind,
- wobei das Verfahren den Schritt aufweist:
- Verlagern der Fokusse (72) relativ zu der Lithografiematerial-Aufnahme (14) durch Verlagerung der Haltematrix (62), und/oder
- Verlagern der Fokusse (72) relativ zu der Lithografiematerial-Aufnahme (14) mittels einer Verlagerung des Objektivs (70),
- Verlagern der Fokusse (72) relativ zu der Lithografiematerial-Aufnahme (14) mittels einer Verlagerung der Lithografiematerial-Aufnahme (14), und/oder
- Verlagern der Fokusse (72) relativ zu der Lithografiematerial-Aufnahme (14) mittels einer optischen Ablenkeinrichtung (68) durch Ablenken der Laser-Schreibstrahlen (26).

7. Laserlithografie-Vorrichtung (10) zum Erzeugen einer dreidimensionalen Struktur in einem Lithografiematerial (12), aufweisend:
- eine Lithografiematerial-Aufnahme (14) zum Aufnehmen des Lithografiematerials (12),
- eine Laserstrahlquelle (18) zum Erzeugen eines Eingangs-Laserstrahls (20),
- eine Demultiplexer-Einheit (24), die zwischen der Laserstrahlquelle (18) und dem Objektiv (70) angeordnet ist,
- wobei die Demultiplexer-Einheit (24) dazu eingerichtet ist, den Eingangs-Laserstrahl (20) durch Demultiplexen zeitlich in eine Mehrzahl von Laser-Schreibstrahlen (26) aufzuteilen,
- ein Objektiv (70) zur Fokussierung der Laser-Schreibstrahlen (26) in jeweils einem dem Laser-Schreibstrahl (26) zugeordneten Fokus (72), und
- eine Scan-Einrichtung (78) zur Verlagerung der Fokusse (72) relativ zu der Lithografiematerial-Aufnahme (14).

8. Laserlithografie-Vorrichtung (10) nach Anspruch 7,
- wobei die Laserstrahlquelle (18) zum Erzeugen eines gepulsten Eingangs-Laserstrahls (20) ausgebildet ist, der eine Mehrzahl von Laserpulsen (34) aufweist,
- wobei die Demultiplexer-Einheit (24) derart ausgebildet ist, dass das Demultiplexen durch ein Auskoppeln einer ersten Gruppe von Laserpulsen (34) und wenigstens einer zweiten Gruppe von Laserpulsen (34) aus dem gepulster Eingangs-Laserstrahl (20) erfolgt,
- wobei die erste Gruppe von Laserpulsen (34) einen ersten Laser-Schreibstrahl (26) bildet und die zweite Gruppe von Laserpulsen (34) einen zweiten Laser-Schreibstrahl (26) bildet.

9. Laserlithografie-Vorrichtung (10) nach Anspruch 7 oder 8,
- wobei die Demultiplexer-Einheit (24) eine Mehrzahl von optischen Schaltern (28) aufweist, die im Strahlengang des Eingangs-Laserstrahls (20) in Reihe nacheinander angeordnet sind,
- wobei jeder optische Schalter (28) in einer geschalteten Stellung dazu eingerichtet ist, einen jeweiligen Laser-Schreibstrahl (26) durch Auskoppeln eines zum Überführen des Lithografiematerials (12) in einen belichteten Zustand ausreichenden Laserstrahl-Anteils zu bilden.

10. Laserlithografie-Vorrichtung (10) nach einem der voranstehenden Ansprüche 7 oder 8,
- wobei die Demultiplexer-Einheit (24) einen optischen Schalter (28) aufweist, der im Strahlengang des Eingangs-Laserstrahls (20) nach der Laserstrahlquelle (18) angeordnet ist,
- wobei die Demultiplexer-Einheit (24) eine optische Anordnung aufweist, die dazu eingerichtet ist, den Eingangs-Laserstrahl (20) mehrmals über den optischen Schalter (28) zu führen,
- wobei der optische Schalter (28) in einer geschalteten Stellung dazu eingerichtet ist, einen Laser-Schreibstrahl (26) durch Auskoppeln eines zum Überführen des Lithografiematerials (12) in einen belichteten Zustand ausreichenden Laserstrahl-Anteils zu bilden.

11. Laserlithografie-Vorrichtung (10) nach einem der voranstehenden Ansprüche 7 bis 10,
- wobei die Laserlithografie-Vorrichtung (10) eine Wellenleiter-Anordnung (54) aufweist, die eine Mehrzahl von Wellenleitern (56) zum Leiten der Mehrzahl von Laser-Schreibstrahlen (26) aufweist, wobei je ein Wellenleiter (56) einem Laser-Schreibstrahl (26) zugeordnet ist,
- wobei die Wellenleiter (56) im Strahlengang zwischen der Demultiplexer-Einheit (24) und dem Objektiv (70) angeordnet sind,
- wobei jeder Wellenleiter (56) ein erstes Ende (58) und ein dem ersten Ende (58) entgegengesetztes zweites Ende (60) aufweist,
- wobei jedes erste Ende (58) zum Einkoppeln eines Laser-Schreibstrahls (26) eingerichtet ist und jedes zweite Ende (60) zum Auskoppeln des in dem ersten Ende (58) eingekoppelten Laser-Schreibstrahls (26) eingerichtet ist,
- wobei die zweiten Enden (60) der Mehrzahl von Wellenleitern (56) von einer Haltematrix (62) der Wellenleiter-Anordnung (54) gehalten sind.

12. Laserlithografie-Vorrichtung (10) nach Anspruch 11,
- wobei die zweiten Enden (60) der Mehrzahl von Wellenleitern (56) von der Haltematrix (62) in einer linearen Anordnung oder in einer zweidimensionalen Anordnung gehalten sind.

13. Laserlithografie-Vorrichtung (10) nach einem der voranstehenden Ansprüche 11 oder 12,
- wobei der Abstand zwischen zwei benachbarten zweiten Enden (60) der Mehrzahl von Wellenleitern (56) 25 µm bis 1000 µm, insbesondere 115 µm bis 600 µm, beträgt.

14. Laserlithografie-Vorrichtung (10) nach einem der voranstehenden Ansprüche 11 bis 13,
- wobei jedes zweite Ende (60) der Mehrzahl von Wellenleitern (56) eine Stirnfläche aufweist, die dazu eingerichtet ist, den in dem ersten Ende (58) eingekoppelten Laser-Schreibstrahl (26) auszukoppeln,
- wobei die Stirnflächen der zweiten Enden (60) in einer Ebene angeordnet sind.

15. Laserlithografie-Vorrichtung (10) nach einem der voranstehenden Ansprüche 11 bis 14,
- wobei die Scan-Einrichtung (78) dazu eingerichtet ist, die Fokusse (72) relativ zu der Lithografiematerial-Aufnahme (14) mittels einer Verlagerung der Haltematrix (62) zu verlagern.
